(19) Europäisches Patentamt
European Patent Office
Office européen des brevets

(11) Veröffentlichungsnummer: **0 180 122 B1**

# (12) EUROPÄISCHE PATENTSCHRIFT

(45) Veröffentlichungstag der Patentschrift: **23.10.91**

(51) Int. Cl.$^5$: **G03F 7/26**

(21) Anmeldenummer: **85113310.8**

(22) Anmeldetag: **21.10.85**

## (54) Entwickler für belichtete negativ arbeitende Reproduktionsschichten sowie Verfahren zur Herstellung von Druckformen und Verwendung des Entwicklers.

(30) Priorität: **30.10.84 DE 3439597**

(43) Veröffentlichungstag der Anmeldung:
**07.05.86 Patentblatt 86/19**

(45) Bekanntmachung des Hinweises auf die Patenterteilung:
**23.10.91 Patentblatt 91/43**

(84) Benannte Vertragsstaaten:
**AT BE CH DE FR GB IT LI NL SE**

(56) Entgegenhaltungen:
**EP-A- 0 027 932**
**EP-A- 0 080 042**
**GB-A- 1 102 952**
**EP-A- 0 056 138**
**DE-A- 3 439 220**
**GB-A- 2 110 401**

(73) Patentinhaber: **HOECHST AKTIENGESELLSCHAFT**
**Postfach 80 03 20**
**W-6230 Frankfurt am Main 80(DE)**

(72) Erfinder: **Mack, Gerhard, Dr. Dipl.-Chem.**
**Mainstrasse 32**
**W-6200 Wiesbaden(DE)**
Erfinder: **Müller, Birgit**
**Freiherr-vom-Stein-Strasse 9**
**W-6200 Wiesbaden-Nordenstadt(DE)**
Erfinder: **Jung, Günter**
**Zum Schwimmbad 5**
**W-6204 Taunusstein 1(DE)**
Erfinder: **Frass, Werner, Dr. Dipl.-Chem.**
**Erbsenacker 37**
**W-6200 Wiesbaden(DE)**

**EP 0 180 122 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Entwickler für belichtete negativ arbeitende Reproduktionsschichten sowie Verfahren zur Herstellung von Druckformen und Verwendung des Entwicklers

Die Erfindung betrifft ein Entwicklergemisch, das zum Entwickeln von negativ arbeitenden belichteten Reproduktionsschichten in Kopiermaterialien geeignet ist sowie ein Verfahren zur Herstellung von Druckformen und die Verwendung des Entwicklers.

Kopiermaterialien der genannten Art werden insbesondere bei der Herstellung von Druckplatten oder von Photoresists verwendet und bestehen aus einem Schichtträger und einer negativ arbeitenden lichtempfindlichen Reproduktionsschicht. Als Schichtträger in diesen Kopiermaterialien werden Metalle wie Zink, Chrom, Kupfer, Messing, Stahl, Aluminium oder Kombinationen dieser Metalle, Kunststoffolien, Papier oder ähnliche Materialien verwendet. Diese Schichtträger können ohne eine modifizierende Vorbehandlung, bevorzugt aber nach Durchführung einer Oberflächenmodifizierung wie einer mechanischen, chemischen oder elektrochemischen Aufrauhung, einer Oxidation und/oder einer Behandlung mit Hydrophilierungsmitteln (z.B. bei Offsetdruckplatten Trägern), mit der lichtempfindlichen Reproduktionsschicht beschichtet werden. Die erfindungsgemäß zu entwickelnden Reproduktionsschichten enthalten wasserunlösliche Diazoniumsalz-Polykondensationsprodukte. Neben der lichtempfindlichen Komponente können die Reproduktionsschichten auch noch Weichmacher, Pigmente, Farbstoffe, Netzmittel, Sensibilisatoren, Indikatoren und andere übliche Hilfsmittel enthalten. Ausführlich werden solche Reproduktionsschichten beispielsweise in der DE-A 20 65 732 (= US-A 38 67 147) beschrieben.

Ein Entwickler für negativ arbeitende Reproduktionsschichten muß die nicht von elektromagnetischer Strahlung (z. B. Licht) getroffenen Schichtteile (die spauateren Nichtbildstellen) aus der belichteten Schicht herauslösen können, ohne dabei die von der Strahlung getroffenen Teile (die späteren Bildstellen) der Schicht wesentlich zu beeinflussen. In der vorher aufgeführten DE-A werden dazu allgemein als geeignet genannt: Wasser, Wasser/organische Lösemittel-Gemische, wäßrige Salzlösungen, wäßrige Säurelösungen, wäßrig-alkalische Lösungen und unverdünnte organische Lösemittel, denen gegebenenfalls Tenside und/oder Hydrophilierungsmittel zugesetzt werden können. Die in den Beispielen hauptsächlich eingesetzten Entwickler enthalten Wasser, Na-laurylsulfat, Na-sulfat, Weinsäure und gegebenenfalls Benzylalkohol; andere Entwickler enthalten oder bestehen aus Isopropanol, n-Propanol, n-Propylacetat, Polyacrylsäure, 1,1,1-Trichlorethan, Aceton oder Ethylenglykol-monomethylether.

Es sind aus dem Stand der Technik auch noch die folgenden Entwickler bzw. Entwicklergemische bekannt geworden:

In der DE-B 10 47 016 wird der Zusatz von 3 bis 5 Gew.-% an Propylenoxid-Ethylenoxid-Blockpolymerisaten mit endständigen Ethlyenoxid-Einheiten in einem wäßrigen, Phosphorsäure enthaltenden Entwickler für Diazoniumverbindungen aufweisende lichtempfindliche Kolloidschichten von Flachdruckplatten beschrieben.

Die wäßrigen, alkalischen Entwickler der DE-B 11 93 366 (= US-A 32 01 241) für Negativ-Schichten von Flachdruckplatten enthalten 0,3 bis 5 Gew.-% an Alkalien, 0,001 bis 0,05 Gew.-% an bestimmten Kationen wie $Ca^{2+}$, $Sr^{2+}$ oder $Ba^{2+}$, 0,001 bis 0,25 Gew.-% an Komplexbildnern wie Weinsäure, Ascorbinsäure oder Ethylendiamin-tetraessigsäure und 0,2 bis 0,8 Gew.-% an wasserlöslichen Polymeren wie Polyethylenglykolen oder Celluloseethern. Wenn die p-Chinondiazide als lichtempfindliche Verbindung enthaltenden Negativ-Schichten noch Bindemittel aufweisen, werden im allgemeinen dem Entwickler noch organische Lösemittel wie Ethylenglykol-monomethylether zugesetzt.

Aus der DE-B 17 72 457 (= US-A 37 01 657) ist ein nicht-wäßriger Entwickler für Flachdruckplatten mit einem photopolymerisierbaren Harz bekannt, der ein organisches Lösemittel, ein niedermolekulares Tensid und gegebenenfalls als Hydrophilierungmittel eine niedermolekulare Säure wie Zitronensäure oder Phosphorsäure oder ein hydrophiles Kolloid wie Carboxymethylcellulose enthält. Als geeignete Tenside werden u. a. Alkylarylsulfonsäuren und Polykondensationsprodukte aus Ethylenoxid und Alkoholen, Fettalkoholen, Alkylphenolen oder Fettaminen genannt.

Der Entwickler für Negativ-Schichten gemäß der DE A 21 24 672 (= US-A 36 69 660) enthält Wasser und eine wasserlösliche Sulfonsäure (insbesondere aromatische Verbindungen) oder eines ihrer wasserlöslichen Salze und gegebenenfalls ein wasserlösliches organisches Lösemittel, ein Tensid und eine Säure wie Phosphorsäure. Die zu entwickelnden lichtempfindlichen Schichten sollen auf der Basis von p-Diazodiphenylamin aufgebaut sein; der Entwickler enthält die Sulfonsäureverbindung in einem Anteil von 5 bis 25 Gew.-%, das organische Lösemittel in einem Anteil von 0 bis 20 Gew.-%, bis zu 5 Gew.-% des Tensids (z. B. Na-laurylsulfat) und bis zu 5 Gew.-% der Säure.

In der DE-A 23 53 992 (= US-A 4 147 545) wird ein Entwickler für Negativ-Schichten beschrieben, der ein wasserlösliches Lithiumsalz einer organischen Verbindung mit wenigstens einem aciden H-Atom und

gegebenenfalls ein amphoteres Tensid enthält. Zu den geeigneten Lithiumsalzen zählen u. a. Li-dodecanoat, -laurylsulfonat, -chloracetat, -caprylat, -stearat und -oleat, sie werden in einem Anteil von 1 bis 25 Gew.-% der wäßrigen Lösung zugesetzt; das amphotere Tensid kann in einem Anteil von bis zu 50 Gew.-% im Entwickler vorhanden sein. Außerdem kann der Entwickler noch bis zu 30 Gew.-% eines organischen Lösemittels, bis zu etwa 10 Gew.-% eines nichtionischen oberflächenaktiven Mittels und bis zu 5 Gew.-% Phosphorsäure oder Oxalsäure enthalten. Die zu entwikkelnde lichtempfindliche Schicht ist auf der Basis von wasserunlöslichen Diazoniumverbindungen oder von photopolymerisierbaren Verbindungen aufgebaut.

Die amphoteren Tenside enthalten sowohl eine Gruppierung mit einem basischen Stickstoffatom als auch eine Gruppierung mit einer sauren Funktion wie einem Carboxyl-, Sulfat-, Sulfonat- oder Phosphatrest. Ein weiterer Zusatz können auch ionogene oder nichtionogene Tenside in einem Anteil von 5 bis 10 Gew.-% sein, u. a. werden Polyethylenglykolether von Alkoholen oder Alkylphenolen genannt.

Der Entwickler zur Behandlung von Diazoniumsalz Polykondensationsprodukte enthaltenden Negativschichten nach der DE-A 25 30 502 (= GB-A 1 515 174) enthält einen größeren Anteil Wasser, eine kleinere Menge eines organischen Lösemittels und ein wasserlösliches Kolloid. Außerdem kann ein solcher Entwickler noch bis zu 10 Gew.-% eines Tensids und bis zu 20 Gew.-% eines Salzes oder einer Säure (u. a. Sulfate, Phosphate, Salpetersäure, Phosphorsäure) aufweisen; als geeignete Tenside werden u. a. Na-laurylsulfat, Alkyl-polyethylenglykolether und Alkylphenol-polyethylenglykolether genannt.

Aus der DE-A 27 44 097 (= US-A 4 186 006) ist ein Entwickler für ein wasserunlösliches Diazoharz und ein hydrophobes Harz enthaltende lichtempfindliche Schichten bekannt, der a) Benzylalkohol, Ethylenglykolmonophenylether oder -monobenzylether, b) ein anionisches Tensid und c) ein wasserlösliches Sulfit enthält.

Aus der EP-A 0 056 138 ist ein Verfahren und ein Entwicklergemisch zum Entwickeln von belichteten, negativarbeitenden Diazoniumsalzschichten bekannt, das aus Wasser, einem Salz einer Alkansäure und einem nichtionogenen Tensid aufgebaut ist. Dabei sollen die genannten Bestandteile in einem gewissen Verhältnis zueinander stehen.

Die EP-B 0 033 232 beschreibt ein Verfahren zum Entwikkeln eines bildgerecht exponierten, negativ arbeitenden Flachdruckformenmaterials mit einem im wesentlichen wäßrigen Entwickler, der ein nichtionisches Tensid und zusätzlich ein Salz einer aliphatischen Carbonsäure mit bis zu 9 Kohlenstoffatomen enthält.

Die EP-A 0 080 042 beschäftigt sich mit einem Entwickler zur Entfernung der unbelichteten Bereiche lichtempfindlicher Beschichtungen, die ein hochmolekulares Polymer enthalten. Der Entwickler enthält ein oberflächenaktives Mittel, organisches Lösemittel, ein alkalisch reagierendes Mittel, z. B. alkalisch reagierende Salze, Amine oder Imine sowie 0,01 bis 5,0 Gew.-% eines Wasserenthärtungsmittels.

Aus der GB-A 2 110 401 ist ein Entwickler bekannt, der aus einem mit Wasser mischbaren Lösemittel für das Bindemittel und Wasser sowie einem Gemisch aus einem hydrophilen anionischen, oberflächenaktiven Mittel und einem organophilen nichtionischen oberflächenaktiven Mittel besteht.

In der EP-B 0 004 014 ist eine zum Entwickeln von belichteten lichtempfindlichen, ein Diazoniumsalz-Polykondensationsprodukt und ein wasserunlösliches organisches Polymeres enthaltenden Kopierschichten bestimmte Entwicklerlösung bekannt, die aus einer gepufferten wäßrigen Lösung eines wasserlöslichen Polymeren, eines anionischen Netzmittels und eines mit Wasser mischbaren organischen Lösemittels besteht und deren pH im Bereich von 3 bis 9 liegt, deren kennzeichnendes Merkmal darin besteht, daß die Lösung 0,5 bis 15 Gew.-% anionisches Netzmittel, als wasserlösliches Polymeres 0,5 bis 6 Gew.-% Poly-N-vinylmethyl-acetamid oder 1 bis 5 Gew.-% Polyvinylalkohol, 0,5 bis 6 Gew.-% eines den pH-Wert in dem angegebenen Bereich stabilisierenden Salzes oder Salzgemisches, von 0,5 Gew.-% bis zur Sättigungskonzentration Benzylalkohol und von 0,5 Gew.-% bis zur Sättigungskonzentration Glycerintriacetat enthält.

In der DE-A 2941960 wird ein Entwicklergemisch zum Auswaschen von bildmäßig belichteten lichtempfindlichen Kopierschichten, enthaltend ein Polymerisat eines N-Vinylamins, des Vinylalkohols oder eines Vinylalkoholderivats, einen in Wasser zu weniger als 10 Gew.-% löslichen Alkohol sowie Wasser als Hauptbestandteil beschrieben, dessen kennzeichnendes Merkmal darin besteht, daß es ein wasserlösliches oder in Wasser zu einer stabilen Dispersion dispergierbares Mischpolymerisat aus

a) hydrophilen Einheiten der Formel I

$$-\ CH_2\ -\ \underset{\substack{|\\ A}}{CH}\ -\ , \qquad \mathrm{I}$$

worin A O-R oder 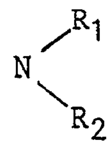 ,

R ein Wasserstoffatom oder eine Methylgruppe,

$R_1$ ein Wasserstoffatom, eine Alkylgruppe oder eine Alkoxyalkylgruppe mit jeweils 1 bis 10 Kohlenstoffatomen odereine Arylgruppe mit 6 bis 10 Kohlenstoffatomen und

$R_2$ eine Alkylgruppe oder eine Acylgruppe mit jeweils 1 bis 5 Kohlenstoffatomen

bedeutet und wobei ein Homopolymerisat aus den hydrophilen Einheiten wasserlöslich ist, und

b) hydrophoben Einheiten von Vinylmonomeren, deren Homopolymerisat wasserunlöslich ist und die als Substituenten einen aromatischen oder einen langkettigen aliphatischen Rest aufweisen,

enthält, wobei der Mengenanteil der hydrophoben Einheiten so groß ist, daß eine 0,1%ige Lösung des Mischpolymerisats eine Oberflächenspannung von nicht mehr als 50 mN/m aufweist, und daß die Menge des Mischpolymerisats mindestens ausreichend ist, um die gegebenenfalls vorhandene, die Löslichkeitsgrenze überschreitende Menge des Alkohols zu emulgieren.

Die aus dem geschilderten Stand der Technik bekannten Entwickler bzw. Entwicklergemische weisen aber insbesondere folgende Nachteile auf:

- Sie enthalten oftmals höhere Anteile an organischem Lösemittel, die aus ökologischen Gründen (niedrigsiedend, feuergefährlich, unangenehm riechend, negative Beeinflussung von Abwasser und Abluft, aufwendige Vorkehrungen zur Beseitigung der Lösemittel nach der Entwicklung) möglichst nicht mehr in zeitgemäßen Entwicklern vorhanden sein sollten.
- Das in der Praxis bisher oftmals eingesetzte Laurylsulfat oder andere Alkansulfate oder Alkansulfonate sind zwar an sich wirksame Entwicklerkomponenten für die angegebenen lichtempfindlichen Reproduktionsschichten, sie erfordern aber eine verhältnismäßig lange Entwicklungszeit, sie schäumen in Verarbeitungsmaschinen zu stark, insbesondere bei Vertikalentwicklung, und die Löslichkeit bei niedrigen Temperaturen (z. B. ab etwa 10° C und tiefer) in Wasser sinkt in einem Ausmaß, daß bei herbstlichen oder winterlichen Temperaturen flockige Rückstände in den Stammlösungen anfallen können, die für den Verarbeiter oftmals störend sind. Fettflecken und Klebstoffreste, wie sie bei der Handhabung von Offsetdruckplatten unter Praxisbedingungen auftreten können, werden von diesen Entwicklerkomponenten höchstens nach langer Einwirkzeit und durch zusätzliche mechanische Hilfen entfernt.
- Sie sind häufig zwar bei Anwendung für die speziellen Reproduktionsschichten, für die sie entwickelt wurden, und bei denen sie in den jeweiligen Beispielen auch erfolgreich eingesetzt wurden, auch geeignet, zeigen aber bei von diesen speziellen Reproduktionsschichten verschiedenen Schichten mehr oder weniger große Schwierigkeiten; d. h. sie sind nicht universell einsetzbar
- Sie sind nicht geeignet, generell die in vielen Fällen, hauptsächlich bei maschineller Entwicklung, auftretenden Verunreinigungen (Fladen und Fädchen), die sich als Redeponierungen auf den Druckformen ablagern, zu unterbinden, so daß keine optimale Qualität des Endproduktes - auch bei längerem Gebrauch des Entwicklers - erreicht werden kann.

Es stellte sich somit die Aufgabe, einen Entwickler für negativ arbeitende belichtete Reproduktionsschichten herzustellen, der neben optimalen Entwicklungseigenschaften (gute Auflösung der Nichtbildstellen und Nichtangriff der Bildstellen) schnell entwickelt, um in automatischen Verarbeitungsanlagen eingesetzt zu werden, der ohne Fladen- und Fädchenbildung aufentwickelt und hohe Ergiebigkeit aufweist, d. h. auch über einen längeren Zeitraum in seinem Entwicklungsverhalten brauchbar ist, ohne Verunreinigungen zu bilden, und der sowohl bei bindemittelhaltigen als auch bindemittelfreien Systemen verwendet werden kann.

Ausgehend von einem Stand der Technik, wie er in der EP-A 0 080 042 beschrieben ist, wird die Aufgabe gelöst durch einen Entwickler zum Entwickeln von einer auf einem Träger befindlichen negativ arbeitenden belichteten Reproduktionsschicht, bestehend aus einem Gemisch aus Wasser, wenigstens einem organischen Lösemittel, wenigstens einem alkalisch reagierenden Mittel, wenigstens einem Komplexbildner und wenigstens einem oberflächenaktiven Mittel, dessen kennzeichnendes Merkmal darin besteht, daß das oberflächenaktive Mittel anionisch aufgebaut ist und daß zusätzlich wenigstens ein Emulgator und wenigstens eine n-Alkansäure und/oder deren Salze und wenigstens eine Puffersubstanz im Gemisch vorhanden sind.

Wenn auch die Komponenten des Entwicklers einzeln oder auch in teilweiser Kombination aus dem Stand der Technik bekannt sind, so war es doch überraschend, daß durch die erfindungsgemäße Entwicklerzusammensetzung die gestellte Aufgabe in allen Belangen zufriedenstellend gelöst werden konnte.

In bevorzugter Ausführung besitzen die eingesetzte n-Alkansäure und/oder deren Salze 8 bis 12 Kohlenstoffatome und sind in dem Gemisch mit 1,0 bis 7,0, insbesondere 1,5 bis 6,0, Gew.-% enthalten. Besonders gute Ergebnisse werden mit Capryl-, Pelargon-, Caprin- und Laurinsäure erzielt. Der Gehalt an Komplexbildner im Gemisch beträgt vorzugsweise 0,5 bis 9,0, insbesondere 1,0 bis 4,0, Gew.-%. Wenn auch grundsätzlich alle gängigen Komplexbildner im Entwickler Verwendung finden können, so haben sich besonders Polyphosphate und hier wieder hauptsächlich Metaphosphate wie z. B. Kurrol-, Madrell- und Grahamsalze bewährt. Gute Ergebnisse zeigten auch Alkali salze, z. B. Natriumsalze, der Nitrilotriessigsäure und der Ethylendiamintetraessigsäure.

Das oder die anionische(n) oberflächenaktive(n) Mittel werden im Gemisch mit 0,2 bis 12,0, vorzugsweise mit 1,0 bis 8,0, Gew.-% eingesetzt. Wenn auch viele anionische oberflächenaktive Mittel eingesetzt werden können, so haben sich vor allem solche bewährt, die aus der Gruppe Alkali-, vorzugsweise Natrium-, octylsulfate, Alkalisalz, vorzugsweise Natriumsalz, der Dodecylsulfonsäure, Alkylphenolethersulfate, Alkali-, vorzugsweise Natrium-, sulfosuccinate, Alkyletherphosphate, Alkali-, vorzugsweise Natrium-, ölsäuremethyltaurid und Naphthalinsulfonate, ausgewählt sind.

Der bevorzugte Gehalt an Emulgator im Entwicklergemisch beträgt 0,5 bis 10,0, vorzugsweise 1,0 bis 6,0, Gew.-%. Als Emulgator werden hauptsächlich Produkte eingesetzt, die aus der Gruppe Poly-N-vinyl-N-methylacetamid, wasserlösliche Copolymere des N-Vinyl-N-methylacetamid, Polyvinylalkohol, Dextrin, Gummi arabicum und Celluloseether, insbesondere Carboxymethylcellulose, ausgewählt sind.

Der Anteil an organischem Lösemittel im Gemisch liegt zweckmäßig bei 0,5 bis 13,0, vorzugsweise bei 1,0 bis 8,0, Gew.-%. Zahlreiche bekannte organische Lösemittel können Verwendung finden, jedoch haben sich besonders solche in der Praxis bewährt, die aus der Gruppe Benzylalkohol, Ethylenglykolmonophenylether, 1-Phenylethanol, 2-Phenylethanol und Propylenglykolmonomethylether ausgewählt sind.

Als puffernde Systeme sind grundsätzlich alle diejenigen geeignet, die vorzugsweise im pH-Bereich von 8 bis 12 wirksam sind. Vor allem werden jedoch die allgemein zugänglichen Puffersubstanzen aus der Gruppe Carbonate, Phosphate, Borate, Alkalisalze des Glycins und Amine, dabei vorzugsweise Diethanolamin und Triethanolamin, verwendet. Sehr gebräuchliche Puffersysteme sind beispielsweise Mischungen aus Carbonat/Hydrogencarbonat, Phosphat/ Hydrogenphosphat u.ä.

Der wäßrige Anteil besteht vorzugsweise aus entionisiertem Wasser.

Der erfindungsgemäße Entwickler ist grundsätzlich für alle negativ arbeitenden Reproduktionsschichten, wie sie zum Stand der Technik gehören, verwendbar.

Diese Reproduktionsschichten können sowohl die bekannten Bindemittel enthalten als auch bindemittelfrei sein.

Bevorzugt wird der Entwickler jedoch bei bindemittelhaltigen Reproduktionsschichten eingesetzt und hierbei insbesondere wieder bei solchen, die Diazoniumsalze enthalten.

Besonders bewährt hat sich der erfindungsgemäße Entwickler bei solchen Reproduktionsschichten, wie sie in der nicht veröffentlichten deutschen Patentanmeldung P 34 04 366.7 der gleichen Anmelderin beschrieben sind, und die im wesentlichen ein lichtempfindliches Gemisch betreffen, das ein Diazoniumsalz-Polykondensationsprodukt und ein nicht lichtempfindliches polymeres Bindemittel mit seitenständigen Carboxylgruppen enthält, das in wäßrig-alkalischen Lösungen löslich oder mindestens quellbar ist, wobei das Bindemittel ein Umsetzungsprodukt eines intramolekularen Anhydrids einer organischen Polycarbonsäure mit einem Hydroxylgruppen enthaltenden synthetischen Polymeren ist, das keine weiteren zur Umsetzung mit Säureanhydriden befähigten funktionellen Gruppen enthält.

Dadurch, daß nur relativ geringe Anteile an organischem Lösemittel im Entwicklergemisch vorhanden sind, ändert dieses seine Zusammensetzung während des Gebrauchs praktisch nicht und hat somit eine verhältnismäßig lange Standzeit in den Entwicklungsvorrichtungen. Im allgemeinen liegt der pH-Wert des erfindungsgemäßen Entwicklergemisches vorzugsweise bei 8 bis 12. Das erfindungsgemäße Entwicklergemisch zeigt keine störende Geruchsbelästigung, und es treten auch bei Temperaturen um den Gefrierpunkt im beanspruchten Mengenbereich der Komponenten keine Ausfällungen auf. Klebstoffreste (z.B vom Aufkleben der Filmvorlagen beim Kopieren) und Fettflecken (z.B. vom Stanzen der Druckplatten) lassen sich mühelos auch bei geringerer Einwirkzeit des Entwicklers entfernen. Die Entwicklungsgeschwindigkeit ist gegenüber herkömmlichen Entwicklern erhöht, ohne daß eine Verringerung der Entwicklerresistenz der Bildbereiche zu beobachten ist. Auch die Salze der Alkansäuren können als kürzerkettige "Seifen" verhältnismäßig leicht abgebaut werden.

Neben den genannten vorteilhaften Eigenschaften ist der weiter überraschende Vorteil des erfindungsgemäßen Entwicklers der, daß die Fladen- und Fädchenbildung, die zu unerwünschten Verunreinigungen des Fertigproduktes und der Verarbeitungsanlage führt, unterbunden wird.

Bei der Entwicklung von Reproduktionsmaterialien sind üblicherweise die Entwickler-, Spül- und

Gummierstation hintereinandergeschaltet. Mit steigender Beladung des Entwicklers mit Schichtbestandteilen kommt es zu einer langsameren und unvollständigen Aufentwicklung. Beim Spülen ist es kaum zu vermeiden, daß aus dem Entwickler wirksame Bestandteile entfernt werden. So werden an der Oberfläche des Reproduktionsmaterials Schichtbestandteile z. B. in agglomerierter Form adsorbiert, die sich als unerwünschte Verunreinigungen bemerkbar machen. Besonders bei hartem Wasser können durch die vorhandenen Calciumionen Bindemittel mit sauren Gruppen zu schwerlöslichen ionischen Additionsprodukten vernetzt werden. Die adsorbierten Schichtbestandteile werden von der Konservierungslösung nicht aufgelöst, jedoch von der Trägeroberfläche als Häutchen abgehoben. Der erfindungsgemäße Entwickler ist auch dann universell einsetzbar, wenn das im Ansatz verwendete Wasser unterschiedliche Härtegrade aufweist. Dies ist besonders wichtig, da die Entwickleransätze an Orten mit unterschiedlich hartem Wasser hergestellt werden.

Die Erfindung betrifft auch ein Verfahren zur Herstellung einer Druckform, wobei man auf einen Träger, vorzugsweise aus Aluminium oder dessen Legierungen, der insbesondere mechanisch und/oder chemisch und/oder elektrochemisch vorbehandelt und/oder hydrophiliert ist, eine negativ arbeitende gegebenenfalls Diazoniumsalze und/oder gegebenenfalls Bindemittel enthaltende Schicht aufbringt, die Schicht bildmäßig belichtet und anschließend mit einem Entwickler aus Wasser, wenigstens einem organischen Lösemittel, wenigstens einem alkalisch reagierenden Mittel, wenigstens einem Komplexbildner und wenigstens einem oberflächenaktiven Mittel behandelt, dessen kennzeichnendes Merkmal darin besteht, daß man dem Entwickler vor und/oder während der Behandlung wenigstens ein anionisch aufgebautes oberflächenaktives Mittel, wenigstens einen Emulgator, wenigstens eine n-Alkansäure und/oder deren Salze und wenigstens eine Puffersubstanz zusetzt.

Vorzugsweise wird innerhalb des Verfahrens mit einem Entwickler behandelt, der in seiner Zusammensetzung voranstehend beschrieben und in den Ansprüchen 2 bis 14 beansprucht wird.

Die Erfindung wird in den folgenden Beispielen näher beschrieben, ohne daß jedoch eine Einschränkung auf die speziellen Ausführungsformen bestehen soll.

Beispiel 1

Eine elektrochemisch aufgerauhte, anodisch oxidierte und mit einer wäßrigen Lösung von Polyvinylphosphonsäure behandelte Aluminiumfolie in Plattenform wird mit einer Lösung aus 100 Gew.-Teilen Ethylenglykol-monomethylether, 50 Gew.-Teilen Tetrahydrofuran, 0,4 Gew.-Teilen Kristallviolett, 0,2 Gew.-Teilen 85%iger Phosphorsäure und 2 Gew.-Teilen eines Polykondensationsproduktes (hergestellt aus 1 mol 3-Methoxy-diphenylamin-4-diazoniumsulfat und 1 mol 4,4'-Bis-methoxymethyl-diphenylether in 85%iger Phosphorsäure, isoliert als Mesitylensulfonat) so beschichtet, daß das Gewicht der Schicht nach dem Trocknen 0,4 g/m$^2$ beträgt. Die lichtempfindliche Offsetdruckplatte wird bildmäßig belichtet und mit einem Entwickler aus 77,0 Gew.-% Wasser, 3,0 Gew.-% Ethylenglycolmonophenylether, 2,0 Gew.-% Grahamsalz, 2,0 Gew.-% Polyvinylmethylacetamid, 4,0 Gew.-% Pelargonsäure, 1,0 Gew.-% festem KOH und 3,0 Gew.-% Triethanolamin entwickelt. Die Aufentwicklungszeit war praxisgerecht, wobei die Nichtbildstellen sauber aufentwickelt waren. Eine Fladen- oder Fädchenbildung war nicht zu beobachten. Auch beim Einsatz des Entwicklers in einer üblichen Maschine zum Entwickeln und Herstellen einer Druckform mit Zwischenspülung und Gummierung waren keine entsprechenden Störungen festzustellen. Von der entwickelten Platte lassen sich in einer Offsetdruckmaschine mehrere Tausend einwandfreie Drucke anfertigen.

Beispiel 2

Es wurde gemäß Beispiel 1 gearbeitet, mit dem Unterschied, daß mit einer Beschichtungslösung gearbeitet wurde, die aus

| | |
|---|---|
| 62 Gew.-Teilen | eines Polymeren, hergestellt durch Rückflußerhitzung unter Verwendung eines Polyvinylbutyrals mit einem Molekulargewicht von etwa 70 bis 80.000, das 71 % Vinylbutyral-, 2 % Vinylacetat- und 27 % Vinylalkoholeinheiten, Maleinsäureanhydrid, Methylethylketon und Trimethylamin enthält, |
| 21 Gew.-Teilen | eines Diazoniumsalz-Polykondensationsproduktes, hergestellt aus 1 mol 3-Methoxy-diphenylamin-4-diazoniumsulfat und 1 mol 4,4' Bismethoxymethyl-diphenylether in 85%iger Phosphorsäure und isoliert als Mesitylensulfonat, |
| 2,5 Gew.-Teilen | Phosphorsäure (85 %), |
| 3 Gew.-Teilen | Viktoriareinblau FGA (C.I.Basic Blue 81) und |
| 0,7 Gew.-Teilen | Phenylazodiphenylamin in |
| 2570 Gew.-Teilen | Ethylenglykolmonomethylether und |

780 Gew.-Teilen Tetrahydrofuran
bestand.

Die so erhaltene Kopierschicht, die nach dem Trocknen ein Schichtgewicht von 0,95 g/m² aufweist, wird unter einer Negativvorlage 30 Sekunden mit einer Metallhalogenid-Lampe von 5 kW Leistung belichtet.

Es wurde der Entwickler gemäß Beispiel 1 verwendet. Es wurden entsprechend gute Ergebnisse gefunden.

Beispiele 3 bis 6

Die Beispiele 1 und 2 wurden wiederholt, nur, daß als n-Alkansäure sowohl Caprylsäure als auch Laurinsäure im Entwickler eingesetzt wurden. Es wurden ähnlich günstige Ergebnisse wie nach den Beispielen 1 und 2 erreicht.

Beispiele 7 bis 29

sind in der folgenden Tabelle zusammengestellt. Bei der Verwendung der dort aufgeführten Entwicklerzusammensetzungen zum Entwickeln der in den Beispielen 1 und 2 genannten Schichten wurden die guten Ergebnisse der Beispiele 3 bis 6 bestätigt.

Tabelle

| Entwicklerzusammensetzung (Gew.-%) | | | | | | |
|---|---|---|---|---|---|---|
| Beispiel | 7 | 8 | 9 | 10 | 11 | 12 |
| Dodecylbenzolsulfonsäure / Na-Salz | 2,0 | 2,0 | - | 2,5 | - | - |
| $K_2CO_3$ | 1,5 | 1,5 | 1,5 | 1,2 | 1,5 | 1,5 |
| $KHCO_3$ | 1,5 | 1,5 | 1,5 | 1,2 | 1,5 | 1,5 |
| Ethylenglycolmonophenylether | 3,0 | 3,0 | 3,0 | 2,5 | 3,0 | 3,0 |
| Grahamsalz | - | - | 2,0 | 1,5 | 2,0 | 2,0 |
| Poly-N-vinyl-N-methylacetamid | 2,0 | 2,0 | 2,0 | 1,8 | 2,0 | 2,0 |
| Pelargonsäure | 4,0 | 4,0 | 4,0 | 2,8 | 2,8 | 4,0 |
| KOH fest | 1,0 | 1,0 | 1,0 | 1,0 | 1,0 | 1,0 |
| Nitrilotriessigsäure | 2,0 | - | - | - | - | - |
| Ethylendiamintetraessigsäure / Na-Salz | - | 2,0 | - | - | - | - |
| Na-Octylsulfat | - | - | 2,0 | - | - | - |
| Alkylphenolethersulfat (Hostapal(R) BV) | - | - | - | - | 2,0 | - |
| Na-Sulfosuccinat (Rewopol(R) SFB) | - | - | - | - | - | 2,0 |
| entionisiertes Wasser | ad 100 % | | | | | |

Tabelle (Fortsetzung I)

| Entwicklerzusammensetzung (Gew.-%) | | | | | | |
|---|---|---|---|---|---|---|
| Beispiel | 13 | 14 | 15 | 16 | 17 | 18 |
| Dodecylbenzolsulfonsäure / Na-Salz | - | - | - | 2,0 | 2,0 | 2,0 |
| $K_2CO_3$ | 1,5 | 1,5 | 1,5 | - | - | - |
| $KHCO_3$ | 1,5 | 1,5 | 1,5 | - | - | - |
| Ethylenglycolmonophenylether | 3,0 | 3,0 | 3,0 | 3,0 | 3,0 | 3,0 |
| Grahamsalz | 2,0 | 2,0 | 2,0 | 2,0 | 2,0 | 2,0 |
| Poly-N-vinyl-N-methylacetamid | 2,0 | 2,0 | 2,0 | 2,0 | 2,0 | 2,0 |
| Pelargonsäure | 4,0 | 4,0 | 4,0 | 4,0 | 4,0 | 4,0 |
| KOH fest | 1,0 | 1,0 | 1,0 | 1,4 | 1,4 | 1,4 |
| Alkyletherphosphat (Forlanon$^{(R)}$ T) | 2,0 | - | - | - | - | - |
| Ölsäuremethyltaurid -Na (Arcopon$^{(R)}$ SN) | - | 2,0 | - | - | - | - |
| kond. Naphthalinsulfonat (Orotan$^{(R)}$ SN) | - | - | 2,0 | - | - | - |
| $Na_3PO_4 \cdot 12\ H_2O$ | - | - | - | 1,25 | - | - |
| $K_2B_4O_7 \cdot 4\ H_2O$ | - | - | - | - | 1,0 | - |
| Glycin - K-Salz | - | - | - | - | - | 1,61 |
| entionisiertes Wasser | ad 100 % | | | | | |

Tabelle (Fortsetzung II)

| Entwicklerzusammensetzung (Gew.-%) | | | | | |
|---|---|---|---|---|---|
| Beispiel | 19 | 20 | 21 | 22 | 23 |
| Na-Octylsulfat | 8,0 | - | - | - | - |
| Ethylengylcolmonophenylether | 5,0 | - | - | - | - |
| Grahamsalz | 2,0 | 2,0 | 2,5 | 2,5 | 2,0 |
| Poly-N-vinyl-N-methylacetamid | 2,0 | 2,0 | 1,5 | 1,5 | 2,0 |
| Pelargonsäure | 4,0 | 4,0 | 2,8 | 2,8 | 4,0 |
| KOH fest | 1,0 | 1,0 | 1,0 | 1,0 | 1,0 |
| Triethanolamin | - | - | - | - | - |
| Diethanolamin | 1,0 | - | - | - | - |
| Dodecylbenzolsulfonsäure Na-Salz | - | 2,0 | 1,5 | 1,5 | 2,0 |
| $K_2CO_3$ | - | 1,5 | 1,0 | 1,0 | 1,5 |
| $KHCO_3$ | - | 1,5 | 1,0 | 1,0 | 1,5 |
| Benzylalkohol | - | 3,0 | - | - | - |
| 1-Phenylethanol | - | - | 2,5 | - | - |
| 2-Phenylethanol | - | - | - | 2,5 | - |
| Propylenglykolmonomethylether | - | - | - | - | 3,0 |
| entionisiertes Wasser | ad 100 % | | | | |

Tabelle (Fortsetzung III)

| Entwicklerzusammensetzung (Gew.-%) | | | | | | |
|---|---|---|---|---|---|---|
| Beispiel | 24 | 25 | 26 | 27 | 28 | 29 |
| Na-Octylsulfat | 2,0 | - | 2,0 | 2,0 | - | - |
| $K_2CO_3$ | 1,5 | 1,5 | 1,5 | 1,5 | 1,5 | 1,5 |
| $KHCO_3$ | 1,5 | 1,5 | 1,5 | 1,5 | 1,5 | 1,5 |
| Ethylenglycolmonophenylether | 3,0 | 3,0 | 3,0 | 3,0 | 3,0 | 3,0 |
| Grahamsalz | 2,0 | 2,0 | 2,0 | 2,0 | 2,0 | 2,0 |
| Dextrin | 2,0 | - | - | - | - | - |
| Polyvinylalkohol | - | 2,0 | - | - | - | - |
| Carboxymethylcellulose | - | - | 2,0 | - | - | - |
| Gummi arabicum | - | - | - | 2,0 | - | - |
| Pelargonsäure | 4,0 | 4,0 | 4,0 | 4,0 | - | - |
| KOH fest | - | 1,0 | - | - | 1,0 | 1,0 |
| NaOH fest | 1,0 | - | 1,0 | 1,0 | - | - |
| Dodecylbenzolsulfonsäure / Na-Salz | - | 2,0 | - | - | 2,0 | 2,0 |
| Poly-N-vinyl-N-methylacetamid | - | - | - | - | 2,0 | 2,0 |
| Caprylsäure | - | - | - | - | 2,5 | - |
| Caprinsäure | - | - | - | - | - | 3,0 |
| entionisiertes Wasser | ad 100 % | | | | | |

Die Entwicklerzusammensetzungen der Beispiele 1 und 3 bis 29 wurden bei Reproduktionsschichten getestet, die aus folgenden Lösungen hergestellt wurden:

A.

| | |
|---|---|
| 1,5 Gew.-% | Diazoniumsalz-Polykondensationsprodukt aus 3-Methoxy-diphenylamin-4-diazoniumsulfat und Formaldehyd, |
| 1,5 Gew.-% | Bindemittel aus einem Umsetzungsprodukt aus Polyvinylbutyral und Maleinsäureanhydrid, |
| 0,1 Gew.-% | Viktoriareinblau FGA (C.I. Basic Blue 81) |
| 0,1 Gew.-% | 85%ige Phosphorsäure |
| 96,8 Gew.-% | Ethylenglykolmonomethylether. |

Das Schichtgewicht nach dem Trocknen betrug 0,8 g/m²

B.

| | |
|---|---|
| 1,5 Gew.-% | Styrol-Maleinsäureanhydrid-Copolymer Halbester (Scripset 540 der Fa. Monsanto) |
| 1,5 Gew.-% | Diazoniumsalz-Polykondensationsprodukt aus 1 mol 3-Methoxydiphenylamin-4-diazoniumsulfat und 1 mol 4,4'-Bis methoxymethyldiphenylether, ausgefällt als Mesitylensulfonat |
| 0,1 Gew.-% | 85%ige Phosphorsäure, |
| 0,1 Gew.-% | Viktoriareinblau FGA (C.I. Basic Blue 81) |
| 96,8 Gew.-% | Ethylenglykolmonomethylether. |

Das Schichtgewicht nach dem Trocknen betrug 0,6 g/m²

C.

| | |
|---|---|
| 97,0 Gew.-Teile | eines Polymeren, hergestellt durch Umsetzung aus 11,3 Gew.-% des in Beispiel 2 genannten Polyvinylbutyrals in Tetrahydrofuran mit 5,11 Gew.-% Propenylsulfonyl-isocyanat in Tetrahydrofuran, |
| 48,3 Gew.-Teiledes | in Beispiel 2 genannten Diazoniumsalz-Polykondensationsproduktes, |
| 4,8 Gew.-Teile | 85%ige Phosphorsäure, |

| | |
|---|---|
| 3,5 Gew.-Teile | Viktoriareinblau FGA (C.I. Basic Blue 81), |
| 1,6 Gew.-Teile | Phenoldiphenylamin in |
| 3500 Gew.-Teilen | Ethylenglykolmonomethylether und |
| 1036 Gew.-Teilen | Tetrahydrofuran. |

Das Schichtgewicht nach dem Trocknen betrug 0,73 g/m$^2$

D.

| | |
|---|---|
| 2 Gew.-Teile | eines teilweise mit Alkanol veresterten Styrol-Maleinsäureanhydrid-Mischpolymerisats mit einem mittleren Molekulargewicht von 20000 und einer Säurezahl um 200, |
| 2 Gew.-Teile | eines Diurethans, hergestellt durch Umsetzung von Glycerindimethacrylat mit Hexamethylendiisocyanat, |
| 0,125 Gew.-Teil | 9-Phenylacridin, |
| 0,05 Gew.-Teil | eines blauen Farbstoffs, erhalten durch Kuppeln von 2,4-Dinitro-6-chlorbenzoldiazoniumsalz mit 2-Methoxy-5-acetylamino-n-cyanethyl-N-hydroxy ethyl-anilin in |
| 25,0 Gew.-Teilen | Butanon und |
| 12,0 Gew.-Teilen | Butylacetat. |

Das Schichtgewicht nach dem Trocknen betrug 3,7 g/m$^2$

Die guten Resultate stimmen mit denen der vorstehenden Beispiele überein. Auch hier überraschte der erfindungsgemäß erzielte Kombinationseffekt aus schneller und guter Entwicklung, hoher Standzeit des Entwicklers bei weitgehender Nichtveränderung in der Zusammensetzung, die Tauglichkeit für schnelle Entwicklungsmaschinen, die weitgehende Umweltfreundlichkeit sowie die absolute Vermeidung der Fladen- und Fädchenbildung bei durchaus unterschiedlichen Reproduktionsschichten.

Durchgeführte Vergleiche zeigten, daß das Weglassen nur eines Bestandteiles in der erfindungsgemäßen Entwicklerzusammensetzung zu unbefriedigenden Ergebnissen in Bezug auf eine langsame und/oder ungenügende Entwicklung, mithin zu Unbrauchbarkeit in den üblichen Entwicklungsstadien und der Nichtverhinderung der Fladen- und Fädchenbildung, führte. Die Endprodukte waren entsprechend von minderer Qualität.

## Patentansprüche

1. Entwickler zum Entwickeln von einer auf einem Träger befindlishen negativ arbeitenden belichtieten Reproduktionsschicht, bestehend aus einem Gemisch aus Wasser, wenigstens einem organischen Lösemittel, wenigstens einem alkalisch reagierenden Mitttel, wenigstens einem Komplexbildner und wenigstens einem anionisch oberflächenaktiven Mittel, dadurch gekennzeichnet, daß wenigstens ein Komplexbildner ausgewählt ist aus der Gruppe Polyphosphate, vorzugsweise Metaphosphate, Alkalisalze der Nitrilotriessigsäure und der Ethylendiamintetraessigsäure und daß zusätzlich wenigstens ein Emulgator und wenigstens eine n-Alkansäure und/oder deren Salze im Gemisch und wenigstens eine Puffersubstanz vorhanden sind.

2. Entwickler nach Anspruch 1, dadurch gekennzeichnet, daß die n-Alkansäure und/oder deren Salze 8 bis 12 Kohlenstoffatome aufweisen.

3. Entwickler nach einem der Ansprüche 1 oder 2, dadurch gekennzeichnet, daß der Gehalt an n-Alkansäure und/ oder deren Salze im Gemisch 1,0 bis 7,0, vorzugsweise 1,5 bis 6,0, Gew. -% betragt.

4. Entwickler nach einem der Ansprüche 1 bis 3, dadurch gekennzeichnet, daß der Gehalt an Komplexbildner im Gemisch 0,5 bis 9,0, vorzugsweise 1,0 bis 4,0, Gew.-% beträgt.

5. Entwickler nach einem der Ansprüche 1 bis 4, dadurch gekennzeichnet, daß der Gehalt an anionischem oberflächenaktivem Mittel im Gemisch 0,2 bis 12,0, vorzugsweise 1,0 bis 8,0, Gew.-% beträgt.

6. Entwickler nach einem der Ansprüche 1 bis 5, dadurch gekennzeichnet, daß der Gehalt an Emulgator im Gemisch 0,5 bis 10,0, vorzugsweise 1,0 bis 6,0, Gew.-% beträgt.

7. Entwickler nach einem der Ansprüche 1 bis 6, dadurch gekennzeichnet, daß der Gehalt an organischem Lösemittel im Gemisch 0,5 bis 13,0, vorzugsweise 1,0 bis 8,0, Gew. -% beträgt.

8. Entwickler nach einem der Ansprüche 1 bis 7, dadurch gekennzeichnet, daß der Gehalt an Puffersubstanz im Gemisch 0,5 bis 20,0, vorzugsweise 1,0 bis 10,0, Gew.-% beträgt.

9. Entwickler nach einem der Ansprüche 1 bis 8, dadurch gekennzeichnet, daß die n-Alkansäure und/oder deren Salze ausgewählt sind aus der Gruppe Capryl-, Pelargon-, Caprin- und Laurinsäure.

10. Entwickler nach einem der Ansprüche 1 bis 9, dadurch gekennzeichnet, daß wenigstens ein anionisches oberflächenaktives Mittel ausgewählt ist aus der Gruppe Alkali-, vorzugsweise Natrium-, octylsulfat, Alkalisalz, vorzugsweise Natriumsalz, der Dodecylsulfonsäure, Alkylphenolethersulfat, Alkali-, vorzugsweise Natrium-, sulfosuccinate, Alkyletherphosphate, Alkali-, vorzugsweise Natrium-, ölsäuremethyltaurid und kondensierte Naphthalinsulfonate.

11. Entwickler nach einem der Ansprüche 1 bis 10, dadurch gekennzeichnet, daß wenigstens ein organisches Lösemittel ausgewählt ist aus der Gruppe Benzylalkohol, Phenoxyethanol, 1-Phenylethanol, 2-Phenylethanol und Propylenglykolmonomethylether.

12. Entwickler nach einem der Ansprüche 1 bis 11, dadurch gekennzeichnet, daß wenigstens ein Emulgator ausgewählt ist aus der Gruppe Poly-N-vinyl-N-methylacetamid, wasserlösliche Copolymere des N-Vinyl-N-methylacetamid, Polyvinylalkohol, Dextrin, Gummi arabicum und Celluloseether, vorzugsweise Carboxymethylcellulose.

13. Entwickler nach einem der Ansprüche 1 bis 12, dadurch gekennzeichnet, daß die Puffersubstanz ausgewählt ist aus der Gruppe Carbonate, Phosphate, Borate, Alkalisalze des Glycins und Amine, vorzugsweise Diethanolamin und Triethanolamin.

14. Verfahren zur Herstellung einer Druckform, wobei man auf einen Träger eine negativ arbeitende, Diazoniumsalze enthaltende Schicht aufbringt, die Schicht bildmäßig belichtet und anschließend mit einem Entwickler gemäß einem oder mehreren der Ansprüche 1 bis 13 behandelt.

15. Verwendung eines Entwicklers nach den Ansprüchen 1 bis 13 zum Behandeln von belichteten negativ arbeitenden, Diazoniumsalze enthaltenden Reproduktionsschichten.

16. Verwendung eines Entwicklers nach Anspruch 15 zum Behandeln von bindemittelhaltigen Reproduktionsschichten.

17. Verwendung eines Entwicklers nach Anspruch 16 zum Behandeln von Schichten, die als Bindemittel ein Polymeres, hergestellt unter Rückflußkühlung unter Verwendung von Polyvinylbutyral mit einem Molekulargewicht von 70 bis 80.000, das 71 % Vinylbutyral-, 2 % Vinylacetat- und 27 % Vinylalkoholeinheiten, Maleinsäureanhydrid, Methylethylketon und Trimethylamin, enthaualt.

## Claims

1. Developer for developing a negative-working exposed reproduction layer located on a base, comprising a mixture of water, at least one organic solvent, at least one agent having an alkaline reaction, at least one complexing agent and at least one anionic surface-active agent, wherein at least one complexing agent is selected from the group consisting of polyphosphates, preferably metaphosphates, alkali metal salts of nitrilotriacetic acid and of ethylenediaminetetraacetic acid and additionally at least one emulsifier and at least one n-alkanoic acid and/or its salts and at least one buffer substance are present in the mixture.

2. The developer as claimed in claim 1, wherein the n-alkanoic acid and/or its salts have 8 to 12 carbon atoms.

3. The developer as claimed in either of claims 1 or 2, wherein the content of n-alkanoic acid and/or its salts in the mixture is 1.0 to 7.0, preferably 1.5 to 6.0, % by weight.

4. The developer as claimed in any one of claims 1 to 3, wherein the content of complexing agent in the mixture is 0.5 to 9.0, preferably 1.0 to 4.0, % by weight.

5. The developer as claimed in any one of claims 1 to 4, wherein the content of anionic surface-active agent in the mixture is 0.2 to 12.0, preferably 1.0 to 8.0, % by weight.

6. The developer as claimed in any one of claims 1 to 5, wherein the content of emulsifier in the mixture is 0.5 to 10.0, preferably 1.0 to 6.0, % by weight.

7. The developer as claimed in any one of claims 1 to 6, wherein the content of organic solvent in the mixture is 0.5 to 13.0, preferably 1.0 to 8.0, % by weight.

8. The developer as claimed in any one of claims 1 to 7, wherein the content of buffer substance in the mixture is 0.5 to 20.0, preferably 1.0 to 10.0, % by weight.

9. The developer as claimed in any one of claims 1 to 8, wherein the n-alkanoic acid and/or its salts are selected from the group consisting of caprylic, pelargonic, capric and lauric acid.

10. The developer as claimed in any one of claims 1 to 9, wherein at least one anionic surface-active agent is selected from the group consisting of alkali octyl sulfate, preferably sodium octyl sulfate, alkali dodecylsulfonate, preferably sodium dodecylsulfonate, alkylphenol ether sulfate, alkali sulfosuccinates, preferably sodium sulfosuccinates, alkyl ether phosphates, alkali oleic acid methyl tauride, preferably sodium oleic acid methyl tauride, and condensed naphthalenesulfonates.

11. The developer as claimed in any one of claims 1 to 10, wherein at least one organic solvent is selected from the group consisting of benzyl alcohol, phenoxyethanol, 1-phenylethanol, 2-phenylethanol and propylene glycol monomethyl ether.

12. The developer as claimed in any one of claims 1 to 11, wherein at least one emulsifier is selected from the group consisting of poly-N-vinyl-N-methylacetamide, water-soluble copolymers of N-vinyl-N-methylacetamide, polyvinyl alcohol, dextrin, gum arabic and cellulose ethers, preferably carboxymethylcellulose.

13. The developer as claimed in any one of claims 1 to 12, wherein the buffer substance is selected from the group consisting of carbonates, phosphates, borates, alkali metal salts of glycine and amines, preferably diethanolamine and triethanolamine.

14. Process for preparing a printing form by applying to a base a negative-working layer which contains diazonium salts, subjecting the layer to imagewise exposure and subsequently treating the layer with a developer as claimed in any one or several of claims 1 to 13.

15. Use of a developer as claimed in claims 1 to 13 for treating exposed negative-working reproduction layers containing diazonium salts.

16. The use of a developer as claimed in claim 15 for treating binder-containing reproduction layers.

17. The use of a developer as claimed in claim 16 for treating layers which contain as the binder a polymer prepared by refluxing using polyvinyl butyral having a molecular weight of 70 to 80,000 which contains 71% vinyl butyral, 2% of vinyl acetate and 27% of vinyl alcohol units, maleic anhydride, methyl ethyl ketone and trimethylamine.

## Revendications

1. Révélateur pour le développement d'une couche de reproduction exposée, travaillant en négatif, se trouvant sur un support, consistant en un mélange d'eau, d'au moins un solvant organique, d'au moins un agent à réaction alcaline, d'au moins un complexant et d'au moins un agent tensioactif anionique, caractérisé en ce qu'au moins un complexant est choisi parmi des polyphosphates, de préférence des métaphosphates, des sels alcalins de l'acide nitrilotriacétique et de l'acide éthylènediaminetétraacétique, et en ce qu'en outre sont présents dans le mélange au moins un émulsifiant et au moins un acide n-alcanoïque et/ou ses sels et au moins une substance tampon.

2. Révélateur selon la revendication 1, caractérisé en ce que l'acide n-alcanoïque et/ou ses sels ont de 8 à 12 atomes de carbone.

3. Révélateur selon la revendication 1 ou 2, caractérisé en ce que la teneur du mélange en acide n-alcanoïque et/ou ses sels est de 1,0 à 7,0, de préférence de 1,5 à 6,0 % en poids.

4. Révélateur selon l'une des revendications 1 à 3, caractérisé en ce que la teneur en complexant du mélange est de 0,5 à 9,0, de préférence de 1,0 à 4,0 % en poids.

5. Révélateur selon l'une des revendications 1 à 4, caractérisé en ce que la teneur en agent tensioactif anionique du mélange est de 0,2 à 12,0, de préférence de 1,0 à 8,0 % en poids.

6. Révélateur selon l'une des revendications 1 à 5, caractérisé en ce que la teneur en émulsifiant du mélange est de 0,5 à 10,0, de préférence de 1,0 à 6,0 % en poids.

7. Révélateur selon l'une des revendications 1 à 6, caractérisé en ce que la teneur en solvant organique du mélange est de 0,5 à 13,0, de préférence de 1,0 à 8,0 % en poids.

8. Révélateur selon l'une des revendications 1 à 7, caractérisé en ce que la teneur en substance tampon du mélange est de 0,5 à 20,0, de préférence de 1,0 à 10,0 % en poids.

9. Révélateur selon l'une des revendications 1 à 8, caractérisé en ce que l'acide n-alcanoïque et/ou ses sels sont choisis parmi l'acide caprylique, l'acide pélargonique, l'acide caprique et l'acide laurique.

10. Révélateur selon l'une des revendications 1 à 9, caractérisé en ce qu'au moins un agent tensioactif anionique est choisi parmi un octylsulfate alcalin, de préférence de sodium, un sel alcalin, de préférence le sel de sodium, de l'acide dodécylsulfonique, un alkylphénol-éthersulfate, des sulfosuccinates alcalins, de préférence de sodium, des alkylétherphosphates, des méthyltaurides alcalins d'acide oléique, de préférence de sodium, et des naphtalènesulfonates condensés.

11. Révélateur selon l'une des revendications 1 à 10, caractérisé en ce qu'au moins un solvant organique est choisi parmi l'alcool benzylique, le phénoxyéthanol, le 1-phényléthanol, le 2-phényléthanol et l'éther monométhylique de propylèneglycol.

12. Révélateur selon l'une des revendications 1 à 11, caractérisé en ce qu'au moins un émulsifiant est choisi parmi le poly-N-vinyl-N-méthylacétamide, des copolymères hydrosolubles du N-vinyl-N-méthylacétamide, le poly(alcool vinylique), la dextrine, la gomme arabique et des éthers de cellulose, de préférence la carboxyméthylcellulose.

13. Révélateur selon l'une des revendications 1 à 12, caractérisé en ce que la substance tampon est choisie parmi des carbonates, phosphates, borates, des sels alcalins de la glycine et des amines, de préférence la diéthanolamine et la triéthanolamine.

14. Procédé pour la préparation d'une forme d'impression, dans lequel on applique sur un support une couche travaillant en négatif, contenant des sels de diazonium, on expose la couche selon l'image et on la traite ensuite par un révélateur selon une ou plusieurs des revendications 1 à 13.

15. Utilisation d'un révélateur selon les revendications 1 à 13, pour le traitement de couches de reproduction travaillant en négatif, exposées, contenant des sels de diazonium.

16. Utilisation d'un révélateur selon la revendication 15, pour le traitement de couches de reproduction contenant des liants.

17. Utilisation d'un révélateur selon la revendication 16, pour le traitement de couches qui contiennent en tant que liant un polymère, préparé par chauffage au reflux avec utilisation d'un poly(butyral de vinyle) ayant une masse moléculaire de 70 à 80 000, qui contient 71 % de motifs butyral de vinyle, 2 % de motifs acétate de vinyle et 27 % de motifs alcool vinylique, d'anhydride maléique, de méthyléthylcétone et de triméthylamine.